(19) Europäisches Patentamt / European Patent Office / Office européen des brevets

(11) **EP 4 253 348 A1**

(12) **EUROPEAN PATENT APPLICATION**

(43) Date of publication:
**04.10.2023 Bulletin 2023/40**

(51) International Patent Classification (IPC):
***C04B 37/02*** *(2006.01)*

(21) Application number: **23164450.1**

(22) Date of filing: **27.03.2023**

(52) Cooperative Patent Classification (CPC):
**C04B 37/026;** C04B 2235/9638; C04B 2237/706;
C04B 2237/708

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **29.03.2022 JP 2022054654**

(71) Applicant: **Proterial, Ltd.
Tokyo 135-0061 (JP)**

(72) Inventor: **OMORI, Teruyuki
Tokyo 135-0061 (JP)**

(74) Representative: **Betten & Resch
Patent- und Rechtsanwälte PartGmbB
Maximiliansplatz 14
80333 München (DE)**

(54) **CERAMIC SUBSTRATE, CERAMIC DIVIDED SUBSTRATE, AND METHOD FOR MANUFACTURING CERAMIC SUBSTRATE**

(57) A ceramic substrate is provided with a flat plate-shaped insulating base including a ceramic, a first brazing material layer provided on a first main surface of the insulating base, a second brazing material layer provided on a second main surface of the insulating base, a first metal layer including a metal and being fixed through the first brazing material layer to the insulating base on a first main surface-side, and a second metal layer including a metal and being fixed through the second brazing material layer to the insulating base on a second main surface-side. A difference between a thickness of the first brazing material layer and a thickness of the second brazing material layer at a given point is 4.0 $\mu$m or less. The ceramic substrate shows very little warpage.

FIG. 1A

EP 4 253 348 A1

**Description**

CROSS-REFERENCE TO RELATED APPLICATIONS

The present application is based on Japanese patent application No. 2022-054654 filed on March 29, 2022, the entire contents of which are incorporated herein by reference.

TECHNICAL FIELD

The present invention relates to a ceramic substrate, a ceramic divided substrate, and a method for manufacturing the same, more particularly, a ceramic circuit board, a ceramic diced circuit board, and a method for manufacturing the same.

BACKGROUND OF THE INVENTION

Conventionally, ceramic substrates (e.g., ceramic circuit boards) with a base (e.g. a substrate) made of highly heat-resistant ceramics are used as substrates for mounting, e.g., electrical circuit components that generate much heat, such as power modules. In the method for manufacturing a metal-ceramic bonded substrate described in Patent Literature 1, a brazing material in the form of paste is applied to both surfaces of a flat plate-shaped ceramic base using the screen printing method, etc., and metal sheets are fixed to the both surfaces of the base by this brazing material. The metal sheets are then partially removed by etching, thereby forming a circuit pattern.

Meanwhile, the present applicant has proposed a ceramic circuit board with a warpage amount of 100 $\mu$m or less per 50 mm at room temperature, which is achieved by cooling a joined body, in which a metal circuit plate and a metal heat dissipation plate are respectively provided on front and back surfaces of a ceramic substrate through a brazing material, at -110°C or less, as described in Patent Literature 2.

Citation List

Patent Literature 1: JP 2021-159926A
Patent Literature 2: JP 2003-309210A

SUMMARY OF THE INVENTION

When using the method described in Patent Literature 2, warpage of ceramic substrates can be suppressed but the process of cooling to -110°C or less increases the cost. Therefore, the present inventors intensively studied the cause of warpage and found that the difference in the thickness of the applied brazing material between one side and the other side at each part of the ceramic base is responsible for the warpage, which led to the present invention. That is, it is an object of the invention to provide a ceramic substrate and a method of manufacturing the same which can suppress warpage while suppressing cost.

To solve the problem described above, one aspect of the invention provides a ceramic substrate, comprising:

a flat plate-shaped insulating base comprising a ceramic;
a first brazing material layer provided on a first main surface of the insulating base;
a second brazing material layer provided on a second main surface of the insulating base;
a first metal layer comprising a metal and being fixed through the first brazing material layer to the insulating base on the first main surface side; and
a second metal layer comprising a metal and being fixed through the second brazing material layer to the insulating base on the second main surface side,
wherein a difference between a thickness of the first brazing material layer and a thickness of the second brazing material layer at a given point is 4.0 $\mu$m or less.

To solve the problem described above, another aspect of the invention provides a ceramic divided substrate that is formed by dividing the ceramic substrate described above into a plurality of pieces.

To solve the problem described above, a still another aspect of the invention provides a ceramic substrate manufacturing method to continuously manufacture a plurality of the ceramic substrates described above, the method comprising:

forming the first brazing material layers by applying a brazing material to the first main surfaces of the insulating bases;

forming the second brazing material layers by applying a brazing material to the second main surfaces of the plurality of the insulating bases; and

forming the first metal layers and the second metal layers by placing metal sheets respectively over the first brazing material layers and the second brazing material layers and then performing brazing,

wherein in the forming the first brazing material layers the forming the second brazing material layers, by using screen printing performed in such a manner that the brazing material is pushed out toward an insulating base-side by a squeegee while replenishing the brazing material onto a screen for a plurality of times, the brazing material is applied to a plurality of the insulating bases after a replenishment of the brazing material and before a next replenishment of the brazing material, and

wherein for each of the insulating bases, a number-of-times value indicating how many times screen printing has been performed after replenishing the brazing material in the forming the first brazing material layers is matched with a number-of-times value indicating how many times screen printing has been performed after replenishing the brazing material in the forming the second brazing material layers.

Advantageous Effects of the Invention

According to the ceramic substrate, the ceramic divided substrate, and the method for manufacturing the same of the invention, it is possible to suppress warpage while suppressing cost.

BRIEF DESCRIPTION OF DRAWINGS

FIG. 1 shows a configuration example of a ceramic substrate in an embodiment of the present invention, wherein FIG. 1A is a plan view showing the front surface, FIG. 1B is a side view, and FIG. 1C is a plan view showing the back surface.

FIG. 2 shows a state in which electrical circuit components are mounted on a front surface of one of ceramic divided substrates and a heat sink as a heat dissipation component is attached to the back surface, wherein FIG. 2A is a plan view and FIG. 2B is a side view.

FIG. 3 is a schematic configuration diagram illustrating a configuration example of a screen printing device.

FIG. 4 is a plan view showing a screen used in the screen printing device.

FIG. 5 is an explanatory diagram illustrating a state in which plural insulating bases are dried in a constant temperature oven.

FIGS. 6A to 6C show a ceramic substrate in a state before etching, wherein FIG. 6A is a plan view showing the front surface, FIG. 6B is a side view, and FIG. 6C is a plan view showing the back surface.

DETAILED DESCRIPTION OF THE INVENTION

Embodiment

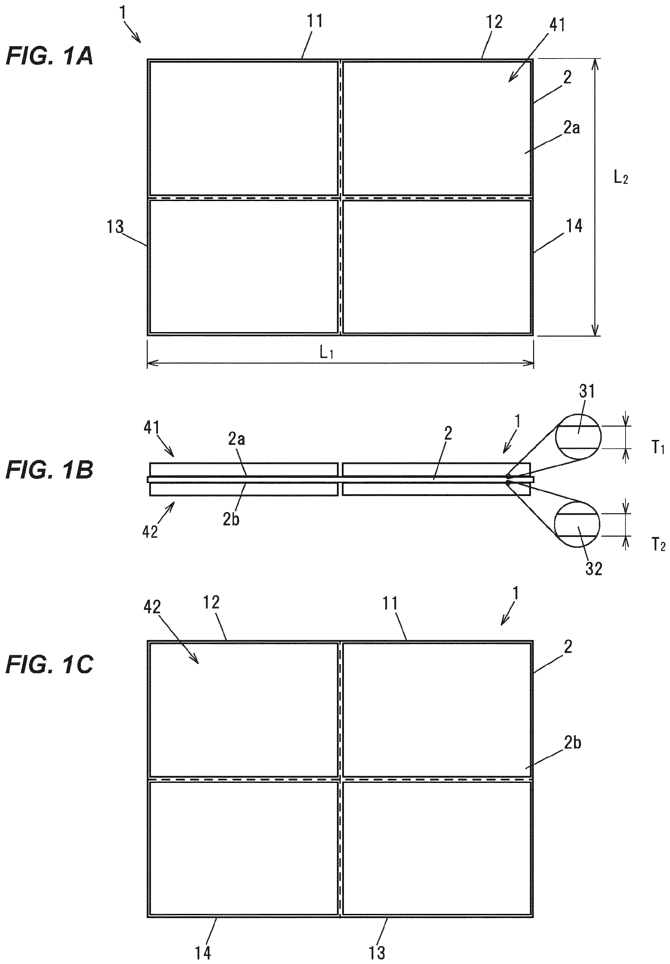

FIG. 1 shows a configuration example of a ceramic substrate in an embodiment of the invention, wherein FIG. 1A is a plan view showing the front surface, FIG. 1B is a side view, and FIG. 1C is a plan view showing the back surface. This ceramic substrate 1 includes a flat plate-shaped insulating base 2 made of a ceramic, a first brazing material layer 31 provided on a first main surface 2a of the insulating base 2, a second brazing material layer 32 provided on a second main surface 2b of the insulating base 2, a circuit plate (i.e., circuit layer) 41 made of a metal and fixed through the first brazing material layer 31 to the insulating base 2 on a first main surface 2a-side, and a heat dissipation plate (i.e., heat dissipation layer) 42 made of a metal and fixed through the second brazing material layer 32 to the insulating base 2 on a second main surface 2b-side.

In present embodiment, the ceramic substrate 1 is a collective substrate (i.e., integrated substrate), more specifically, a ceramic collective circuit board. The ceramic substrate 1 is diced along dashed lines shown in FIGS. 1A and 1C and divided into plural ceramic divided substrates (i.e., ceramic diced substrate) 11 to 14. On each of the plural ceramic divided substrates 11 to 14, electrical circuit components are mounted on the circuit plate 41 and a heat dissipation component is attached to the heat dissipation plate 42. Although the ceramic substrate 1 is divided into the four ceramic divided substrates 11 to 14 in the present embodiment, the number of the divided pieces of the ceramic substrate is not limited four and may be two, three, or not less than five.

The first metal layer 41 and the second metal layer 42 are composed of metal sheets formed to have a uniform thickness. The metal sheets desirably have low electrical resistance and high thermal conductivity. Although the first metal layer 41 and the second metal layer 42 are composed of copper sheets in the present embodiment, the first metal layer 41 and the second metal layer 42 may be composed of aluminum sheets. In this regard, however, to prevent warpage due to a difference in coefficient of thermal expansion, the first metal layer 41 and the second metal layer 42 are desirably made of the same type of metal.

The first metal layer 41 is a circuit plate on which electrical circuit components are mounted. The second metal layer 42 is a heat dissipation plate that dissipates heat generated by electrical circuit components mounted on the first metal layer 41. To suppress warpage of the ceramic substrate 1, a thickness of the first metal layer 41 and a thickness of the second metal layer 42 are desirably about the same, and a difference between the thickness of the first metal layer 41 and the thickness of the second metal layer 42 in the present embodiment is 0.02 mm or less. In more particular, a difference between a thickness value at the thickest portion of the first metal layer 41 and a thickness value at the thinnest portion of the second metal layer 42 and a difference between a thickness value at the thinnest portion of the first metal layer 41 and a thickness value at the thickest portion of the second metal layer 42 are both 0.02 mm or less.

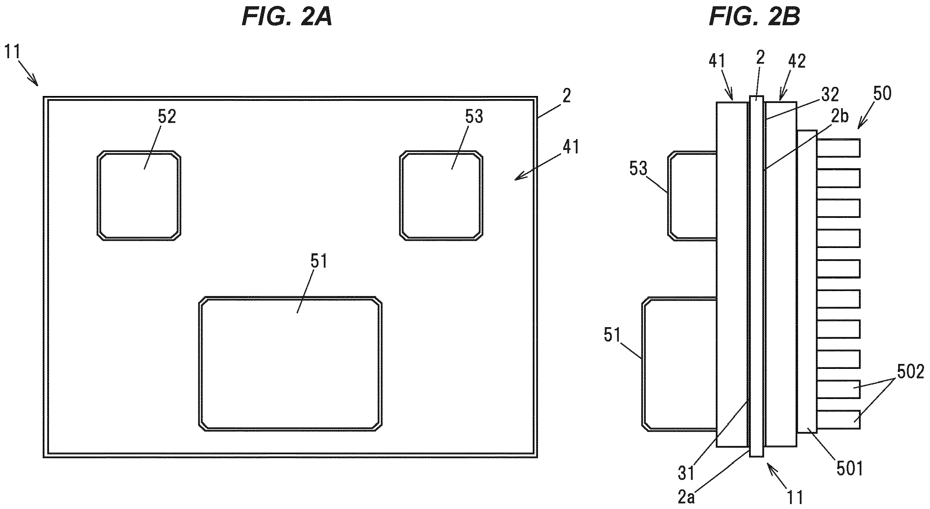

FIGS. 2A to 2C show a state in which first to third electrical circuit components 51 to 53 are mounted on the front side of one ceramic divided substrate 11 and a heat sink 50 as the heat dissipation component is attached on the back side, wherein FIG. 2A is a plan view showing the front surface and FIG. 2B is a side view. The first to third electrical circuit components 51 to 53 are, e.g., power modules, such as transistor or diode, which are heat-generating components. The heat sink 50 has a base plate 501 having a flat plate shape and plural protruding pieces 502 protruding from the base plate 501, and dissipates heat generated by the first to third electrical circuit components 51 to 53 and conducted from the insulating base 2 to the heat dissipation plate 42, into the air. The number of electrical circuit components mounted on each of the ceramic divided substrates 11 to 14 can be not less than one and is not specifically limited. The type, shape, and quantity, etc., of the electric circuit components mounted on the ceramic divided substrates 11 to 14 are not limited to those shown in FIGS. 2A to 2C and can be appropriately changed. The number of electrical circuit components mounted on each of the ceramic divided substrates 11 to 14 can be not less than one and is not specifically limited. In addition, although FIGS. 2A to 2C show an example in which the heat sink 50 is attached on the back side, the heat sink 50 may not be attached on the back side, or electrical circuit components may be mounted also on the back side.

As an example, the insulating base 2 is a silicon nitride substrate which is formed as follows: a slurry as a mixture of silicon powder, a sintering aid and an organic binder is formed in a flat plate shape with a uniform thickness by the doctor blade method, is then cut, subjected to degreasing treatment and nitriding treatment, and further sintered. In the example shown in FIG. 1, the insulating base 2 has a rectangular shape in which a length $L_1$ in a long-side direction is larger than a length $L_2$ in a short-side direction. The first brazing material layer 31 and the second brazing material layer 32 are formed by applying a brazing material, which is obtained by mixing copper powder and silver powder together with a binder and a solvent, to the first main surface 2a and the second main surface 2b of the insulating base 2 using the screen printing method. In this regard, when the raw material of the insulating base 2 is silicon nitride powder instead of silicon powder, the nitriding treatment may be omitted. In addition, the first brazing material layer 31 and the second brazing material layer 32 may be layers not containing silver powder.

Next, a method for manufacturing the ceramic substrate 1 will be described. This manufacturing method is a method for continuously manufacturing plural ceramic substrates 1, e.g., 100 to 200 in a lot, and includes a first brazing material layer forming step of forming the first brazing material layers 31 by applying a brazing material to the first main surfaces 2a of plural insulating bases 2, a second brazing material layer forming step of forming the second brazing material layers 32 by applying a brazing material to the second main surface 2b of the plural insulating bases 2, and a metal layer forming step of forming the first metal layers 41 and the second metal layers 42 by placing metal sheets respectively over the first brazing material layers 31 and the second brazing material layers 32 and then performing brazing and etching. The second brazing material layer forming step is performed after performing the first brazing material layer forming step on all of the plural insulating bases 2 in the lot, and the metal layer forming step is performed after performing the second brazing material layer forming step on all of the plural insulating bases 2 in the lot.

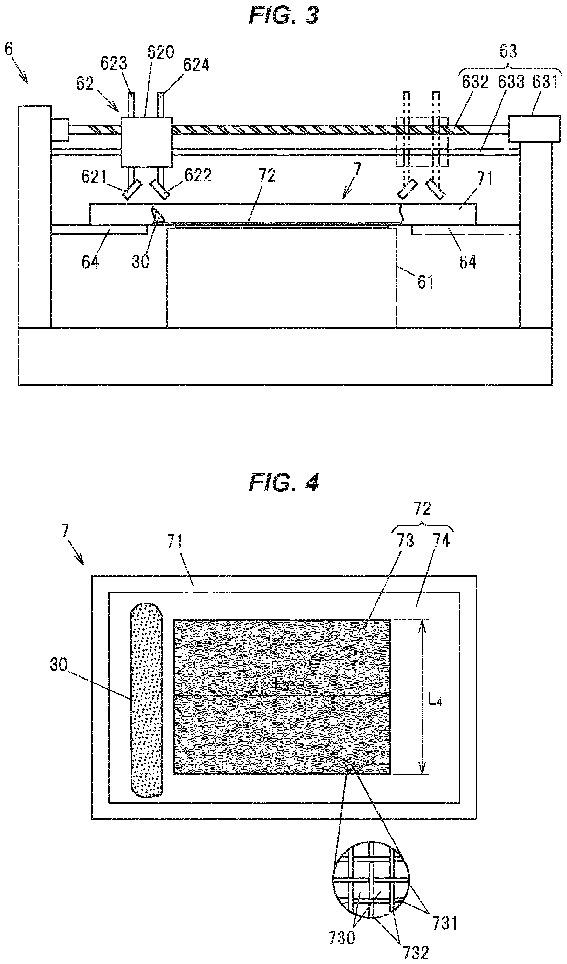

FIG. 3 is a schematic configuration diagram illustrating a configuration example of a screen printing device 6 for screen printing of the brazing material in the first brazing material layer forming step and the second brazing material layer forming step. FIG. 4 is a plan view showing a screen 7 used in the screen printing device 6. The screen printing device 6 has a placement stage 61 on which the insulating base 2 is placed, a squeegee unit 62, a moving mechanism 63 to move the squeegee unit 62 along the long-side direction of the insulating base 2, and a supporting member 64 that immovably supports the screen 7 relative to the placement stage 61. In the first brazing material layer forming step, the insulating base 2 is placed on the placement stage 61 with the first main surface 2a facing vertically upward. In the second brazing material layer forming step, the insulating base 2 is placed on the placement stage 61 with the second main surface 2b facing vertically upward.

As an example, the moving mechanism 63 has an electric motor 631, a ball screw 632, and a guide rail 633, and linearly moves the squeegee unit 62 between an original position shown in solid lines in FIG. 3 and a movement end position shown in dash-dot-dot lines. The squeegee unit 62 includes a unit case 620, a first squeegee 621 for forward travel, a second squeegee 622 for backward travel, a first ascending/descending rod 623 connected to the first squeegee 621, and a second ascending/descending rod 624 connected to the second squeegee 622. The unit case 620 moves above the screen 7 by rotation of the ball screw 632. The first ascending/descending rod 623 and the second ascending/descending rod 624 move vertically relative to the unit case 620, e.g., by hydraulic pressure or pneumatic pressure.

The screen 7 has a frame 71, and a flat plate-shaped screen mask 72 fixed to the frame 71. The screen mask 72 has a mesh portion 73 having plural permeation holes 730 that allow the brazing material 30 in the form of paste to pass through, and a non-mesh portion 74 not having the permeation holes 730. The mesh portion 73 is formed in a rectangular shape and is provided at a position including a central portion on the inner side of the frame 71, and the non-mesh portion 74 is formed so as to surround the outside of the mesh portion 73. In FIG. 3, a portion of the frame 71 is broken to show the screen mask 72.

The mesh portion 73 is composed of plural warp threads 731 stretched parallel to the long-side direction of the insulating base 2 and plural weft threads 732 stretched parallel to the short-side direction of the insulating base 2, which are woven together in a grid pattern, and each area surrounded by two warp threads 731 and two weft threads 732 is the permeation hole 730. A length $L_3$ of the mesh portion 73 along a moving direction of the squeegee unit 62 is slightly smaller than the length $L_1$ of the insulating base 2 along the long-side direction, and a length $L_4$ of the mesh portion 73 along a direction perpendicular to the moving direction of the squeegee unit 62 is slightly smaller than the length $L_2$ of the insulating base 2 along the short-side direction.

The first squeegee 621 comes into contact with the screen mask 72 when the first ascending/descending rod 623 descends, and the first squeegee 621 separates from the screen mask 72 when the first ascending/descending rod 623 ascends. Likewise, the second squeegee 622 comes into contact with the screen mask 72 when the second ascending/descending rod 624 descends, and the second squeegee 622 separates from the screen mask 72 when the second ascending/descending rod 624 ascends. The first squeegee 621 and the second squeegee 622 have a long plate shape extending in a direction perpendicular to the moving direction of the squeegee unit 62, and is formed such that its length in the extending direction is larger than the length $L_4$ of the mesh portion 73 in the same direction.

At the beginning of the first brazing material layer forming step and the second brazing material layer forming step, the brazing material 30 is placed on the non-mesh portion 74 on the original position side of the squeegee unit 62 relative to the mesh portion 73 as shown in FIGS. 3 and 4, and the first squeegee 621 moves on the mesh portion 73 toward the movement end of the squeegee unit 62 while pushing the brazing material 30 out through the permeation holes 730 toward the insulating base 2. Once the squeegee unit 62 moves to the movement end, the first squeegee 621 ascends and the second squeegee 622 descends, and the second squeegee 622 moves on the mesh portion 73 while pushing the brazing material 30 out through the permeation holes 730 toward the insulating base 2. By this single reciprocating movement of the squeegee unit 62, the brazing material 30 with a thickness corresponding to the thickness of the mesh portion 73 is applied to the insulating base 2. Alternatively, application of the brazing material 30 to one insulating base 2 may be done by plural reciprocating movements of the squeegee unit 62 or by one-way movement of the squeegee unit 62 in either the forward or backward direction.

In the first brazing material layer forming step and the second brazing material layer forming step, the brazing material 30 is applied by screen printing performed in such a manner that the brazing material 30 is pushed out toward the insulating base 2-side by the first squeegee 621 and the second squeegee 622 while replenishing the brazing material 30 onto the screen 7 plural times. When screen printing is continuously performed on, e.g., two hundred insulating bases 2 in the first brazing material layer forming step or the second brazing material layer forming step, the brazing material 30 is replenished every time screen printing is performed on ten insulating bases 2, hence, 19 replenishments in total. In this way, in the first brazing material layer forming step and the second brazing material layer forming step, the brazing material 30 is applied to plural insulating bases 2 (ten in the example described above) by the screen printing method after a replenishment of the brazing material 30 and before a next replenishment of the brazing material 30.

In the first brazing material layer forming step, after the brazing material 30 is applied to the first main surfaces 2a of the plural insulating bases 2, this brazing material 30 is solidified by drying in a constant temperature oven. Likewise, in the second brazing material layer forming step, after the brazing material 30 is applied to the second main surfaces 2b of the plural insulating bases 2, this brazing material 30 is solidified by drying in the constant temperature oven. In the metal layer forming step, metal sheets are placed respectively over the first brazing material layer 31 and the second brazing material layer 32 each of which is the solidified brazing material 30, and brazing is performed by heating to about 800°C in a state in which a load is applied to the two metal sheets with the insulating base 2 sandwiched therebetween. After that, each of the metal sheets is partially removed by etching, thereby forming the first metal layer 41 and the second metal layer 42. In this regard, the etching may be omitted by processing the first metal layer 41 and the second metal layer 42 into predetermined shapes in advance.

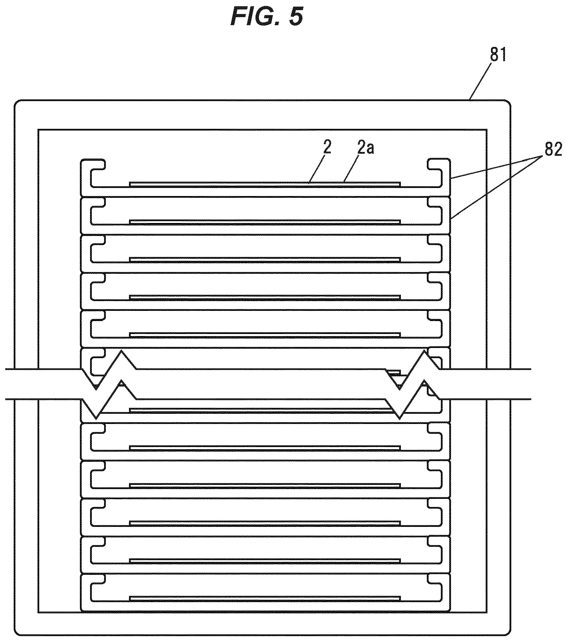

FIG. 5 is an explanatory diagram illustrating a state in which plural insulating bases 2 are dried in a constant temperature oven 81 after the first brazing material layer forming step. The plural insulating bases 2 are placed on trays 82 so that spaces are formed on the first main surface 2a side, and the trays 82 are stacked from the bottom sequentially in the order in which the brazing material 30 is applied in the first brazing material layer forming step. This makes it possible to keep track of the order of the insulating bases 2 to which the brazing material 30 is applied in the first brazing material layer forming step. In the second brazing material layer forming step, the brazing material 30 is applied to the second main surfaces 2b of the plural insulating bases 2 in the order in which the brazing material 30 was applied in the first brazing material layer forming step. In other words, the $n^{th}$ insulating base 2 (n is a natural number not more than the number of the insulating bases 2 in the lot) in applying the brazing material 30 in the first brazing material layer forming step is the $n^{th}$ insulating base 2 also in applying the brazing material 30 in the second brazing material layer forming step. This is a measure taken so that a thickness $T_1$ of the first brazing material layer 31 (see FIG. 1B) and a thickness $T_2$ of the second brazing material layer 32 (see FIG. 1B) are equal for each of the insulating bases 2.

The present inventors have confirmed that when screen printing is performed as described above, the thickness of the applied brazing material 30 is small immediately after replenishing the brazing material 30 on the screen 7, and then gradually becomes larger every time the screen printing is repeated, and the degree of change in the thickness of the brazing material 30 differs depending on the location on the mesh portion 73. It is considered that this is related to an increase in viscosity of the brazing material 30 due to evaporation of volatile components of the binder in the brazing material 30. When the viscosity of the brazing material 30 increases, the brazing material 30 is likely to adhere to the insulating base 2, and the first brazing material layer 31 and the second brazing material layer 32 are likely to become thicker. That is, the thickness of the brazing material 30 on each portion of the insulating base 2, which is applied in the first brazing material layer forming step and the second brazing material layer forming step, is correlated with the number of times of performed screen printing after replenishing the brazing material 30.

The present inventors have also confirmed that the larger the difference between the thickness of the first brazing material layer 31 and the thickness of the second brazing material layer 32, the greater the warpage that occurs in the ceramic substrate 1. The reason is considered as follows: the first brazing material layer 31 and the second brazing material layer 32 contract during cooling after heating in the metal layer forming step. Therefore, when, e.g., the thickness of the first brazing material layer 31 is larger than the thickness of the second brazing material layer 32, the contraction force of the first brazing material layer 31 bends the insulating base 2 so that the first main surface 2a side becomes concave. On the other hand, when the thickness of the second brazing material layer 32 is larger than the thickness of the first brazing material layer 31, the contraction force of the second brazing material layer 32 bends the insulating base 2 so that the second main surface 2b side becomes concave.

For this reason, in the present embodiment, for each of the insulating bases 2, a number-of-times value indicating how many times screen printing has been performed after replenishing the brazing material 30 in the first brazing material layer forming step is matched with a number-of-times value indicating how many times screen printing has been performed after replenishing the brazing material 30 in the second brazing material layer forming step. That is, the insulating base 2 subjected to, e.g., the third screen printing after replenishing the brazing material 30 in the first brazing material layer forming step is also subjected to the third screen printing after replenishing the brazing material 30 in the second brazing material layer forming step. This can reduce the difference between the thickness of the first brazing material layer 31 and the thickness of the second brazing material layer 32 of the ceramic substrate 1, thereby suppressing the amount of warpage of the insulating base 2.

In the present embodiment, the difference between the thickness of the first brazing material layer 31 and the thickness of the second brazing material layer 32 at a given point on the ceramic substrate 1 is 4.0 $\mu$m or less. In addition, a relational expression $(Ta-Tb)/Ta \leq 0.2$ is satisfied where Ta is the larger of the thickness of the first brazing material layer 31 and the thickness of the second brazing material layer 32 at a given point on the ceramic substrate 1 and Tb is the smaller of the two. As a result, in the ceramic substrate 1, the amount of warpage of the insulating base 2 per 100 mm in a direction along each side of the insulating base 2 is 0.03 mm or less. The amount of warpage here is the largest value of deviation at room temperature (20°C) in the thickness direction of the ceramic substrate 1 with respect to a line segment connecting both ends of the measurement area.

Example

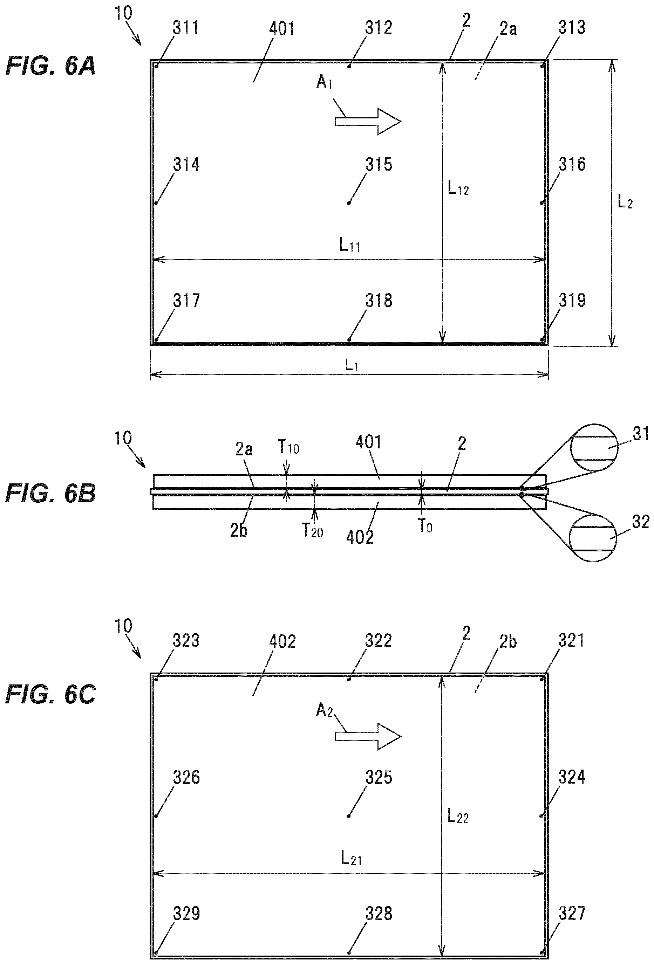

Next, a more specific example of the ceramic substrate 1 will be described. FIGS. 6A to 6C show a ceramic substrate 10 in a state before etching in the metal layer forming step, wherein FIG. 6A is a plan view showing the front surface, FIG. 6B is a side view, and FIG. 6C is a plan view showing the back surface. This ceramic substrate 10 has a first metal sheet 401 brazed by the first brazing material layer 31 to the insulating base 2 on the first main surface 2a-side, and a second metal sheet 402 brazed by the second brazing material layer 32 to the insulating base 2 on the second main surface 2b-side.

The first metal sheet 401 is etched to remove an unnecessary portion and formed into the first metal layer 41, and the second metal sheet 402 is etched to remove an unnecessary portion and formed into the second metal layer 42. In this etching, etching resist patterns having predetermined shapes are formed on the first metal sheet 401 and the second metal sheet 402, and portions of the first metal sheet 401 and the second metal sheet 402 are removed with a chemical solution. After that, portions of the first brazing material layer 31 and the second brazing material layer 32 where the first metal sheet 401 and the second metal sheet 402 have been removed are removed using a chemical solution for removal of the brazing material.

The insulating base 2 has the length $L_1$ of 190.5 mm in the long-side direction, the length $L_2$ of 138.0 mm in the short-side direction, and a thickness $T_0$ of 0.32 mm. The first metal sheet 401 and the second metal sheet 402 are rectangular flat plates and have lengths $L_{11}$ and $L_{21}$ of 188.4 mm in the long-side direction, lengths $L_{12}$ and $L_{22}$ of 133.6 mm in the short-side direction, and thicknesses $T_{10}$ and $T_{20}$ of 0.8 mm. The first brazing material layer 31 and the second brazing material layer 32 are formed to have the same size as the first metal sheet 401 and the second metal sheet 402.

First to ninth measurement points 311 to 319 at which the thickness of the first brazing material layer 31 was measured are shown in FIG. 6A, and first to ninth measurement points 321 to 329 at which the thickness of the second brazing material layer 32 was measured are shown in FIG. 6B. The first measurement point 321 on the second brazing material layer 32 is located behind the first measurement point 311 on the first brazing material layer 31. Likewise, the second to ninth measurement points 322 to 329 on the second brazing material layer 32 are located behind the second to ninth measurement points 312 to 319 on the first brazing material layer 31. Arrows $A_1$ and $A_2$ shown in FIGS. 6A and 6C indicate the direction of forward movement of the squeegee unit 62 at the time of the screen printing in the first brazing material layer forming step and the second brazing material layer forming step.

In addition, as shown in FIGS. 6A and 6C, the first measurement points 311, 321, the third measurement points 313, 323, the seventh measurement points 317, 327, and the ninth measurement points 319, 329 are located at corners of the first metal sheet 401 and the second metal sheet 402. The fifth measurement points 315 and 325 are located at centers of first metal sheet 401 and the second metal sheet 402. The second measurement points 312, 322 and the eighth measurement points 318, 328 are located at centers of the long sides of the first metal sheet 401 and the second metal sheet 402. The fourth measurement points 314, 324 and the sixth measurement points 316, 326 are located at centers of the short sides of the first metal sheet 401 and the second metal sheet 402.

Table 1 shows the thickness of the first brazing material layer 31 at each of the measurement points 311 to 319, the thickness of the second brazing material layer 32 at each of the measurement points 321 to 329, and each thickness difference (a value obtained by subtracting the thickness of the second brazing material layer 32 from the thickness of the first brazing material layer 31), when a number-of-times value of screen printing in the first brazing material layer forming step is matched with a number-of-times value of screen printing in the second brazing material layer forming step. As shown in Table 1, in this Example, the absolute value of the difference between the thickness of the first brazing material layer 31 and the thickness of the second brazing material layer 32 is 4.0 $\mu$m or less at any of the measurement points 311 to 319 and 321 to 329. In addition, the relational expression $(Ta-Tb)/Ta \leq 0.2$ is satisfied where Ta is the larger of the thickness of the first brazing material layer 31 and the thickness of the second brazing material layer 32 and Tb is the smaller of the two.

Table 1

| | Thickness of First brazing material layer 31 ($\mu$m) | Thickness of Second brazing material layer 32 ($\mu$m) | Difference in Thickness ($\mu$m) | $\dfrac{(Ta - Tb)}{Ta}$ |
|---|---|---|---|---|
| First measurement point | 19.5 | 22.1 | -2.6 | 0.118 |
| Second measurement point | 20.4 | 20.0 | 0.4 | 0.020 |
| Third measurement point | 20.2 | 18.3 | 1.9 | 0.094 |
| Fourth measurement point | 13.8 | 11.2 | 2.6 | 0.188 |
| Fifth measurement point | 18.0 | 17.0 | 1 | 0.056 |
| Sixth measurement point | 17.6 | 17.5 | 0.1 | 0.006 |

(continued)

|  | Thickness of First brazing material layer 31 ($\mu$m) | Thickness of Second brazing material layer 32 ($\mu$m) | Difference in Thickness ($\mu$m) | $\dfrac{(Ta - Tb)}{Ta}$ |
|---|---|---|---|---|
| Seventh measurement point | 15.9 | 17.3 | -1.4 | 0.081 |
| Eighth measurement point | 19.3 | 18.5 | 0.8 | 0.041 |
| Ninth measurement point | 17.8 | 16.4 | 1.4 | 0.079 |

Table 2 shows the thickness of the first brazing material layer 31 at each of the measurement points 311 to 319, the thickness of the second brazing material layer 32 at each of the measurement points 321 to 329, and each thickness difference in Comparative Example, when the number-of-times value of screen printing in the first brazing material layer forming step is not matched with the number-of-times value of screen printing in the second brazing material layer forming step. In this Comparative Example, the absolute value of the difference between the thickness of the first brazing material layer 31 and the thickness of the second brazing material layer 32 is more than 4.0 $\mu$m at some of the measurement points 311 to 319.

Table 2

|  | Thickness of First brazing material layer 31 ($\mu$m) | Thickness of Second brazing material layer 32 ($\mu$m) | Difference in Thickness ($\mu$m) | $\dfrac{(Ta - Tb)}{Ta}$ |
|---|---|---|---|---|
| First measurement point | 22.9 | 15.7 | 7.2 | 0.314 |
| Second measurement point | 14.7 | 19.6 | -4.9 | 0.250 |
| Third measurement point | 13.7 | 22.1 | -8.4 | 0.380 |
| Fourth measurement point | 17.8 | 15.0 | 2.8 | 0.157 |
| Fifth measurement point | 15.9 | 17.8 | -1.9 | 0.107 |
| Sixth measurement point | 20.7 | 16.4 | 4.3 | 0.208 |
| Seventh measurement point | 19.3 | 14.3 | 5 | 0.259 |
| Eighth measurement point | 14.5 | 16.7 | -2.2 | 0.132 |

(continued)

| | Thickness of First brazing material layer 31 ($\mu$m) | Thickness of Second brazing material layer 32 ($\mu$m) | Difference in Thickness ($\mu$m) | $\dfrac{(Ta - Tb)}{Ta}$ |
|---|---|---|---|---|
| Ninth measurement point | 14.7 | 14.2 | 0.5 | 0.034 |

In this Comparative Example, warpage of the insulating base 2 was larger than that in Example and the amount of warpage in every 100 mm in a direction along each side of the insulating base 2 was more than 0.03 mm. That is, it was confirmed that by matching the number-of-times value of screen printing in the first brazing material layer forming step with the number-of-times value of screen printing in the second brazing material layer forming step, the difference between the thickness of the first brazing material layer 31 and the thickness of the second brazing material layer 32 can be reduced and the amount of warpage of 0.03 mm or less per 100 mm in a direction along each side of the insulating base 2 can be achieved.

Functions and Effects of the embodiment

In the embodiment described above, warpage of the ceramic substrate 1 can be suppressed by reducing the difference between the thickness of the first brazing material layer 31 and the thickness of the second brazing material layer 32 to 4.0 $\mu$m or less. In addition, by matching the number-of-times value of screen printing in the first brazing material layer forming step with the number-of-times value of screen printing in the second brazing material layer forming step, the difference between the thickness of the first brazing material layer 31 and the thickness of the second brazing material layer 32 at each measurement point can be reduced without adding any processes.

Summary of the embodiment

Technical ideas understood from the embodiment will be described below citing the reference signs, etc., used for the embodiment. However, each reference sign, etc., described below is not intended to limit the constituent elements in the claims to the members, etc., specifically described in the embodiment.

According to the first feature, a ceramic substrate 1 includes: a flat plate-shaped insulating base 2 including a ceramic; a first brazing material layer 31 provided on a first main surface 2a of the insulating base 2; a second brazing material layer 32 provided on a second main surface 2b of the insulating base 2; a first metal layer 41 including a metal and being fixed through the first brazing material layer 31 to the insulating base 2 on the first main surface 2a side; and a second metal layer 42 including a metal and being fixed through the second brazing material layer 32 to the insulating base 2 on the second main surface 2b side, wherein a difference between a thickness of the first brazing material layer 31 and a thickness of the second brazing material layer 32 at a given point is 4.0 $\mu$m or less.

According to the second feature, in the ceramic substrate 1 as described by the first feature, a relational expression Ta-Tb/Ta$\leq$0.2 is satisfied where Ta is the larger of the thickness of the first brazing material layer 31 and the thickness of the second brazing material layer 32 at a given point and Tb is the smaller of the two.

According to the third feature, in the ceramic substrate 1 as described by the first or second features, one of the first metal layer 41 and the second metal layer 42 includes a circuit plate on which an electrical circuit component 51 to 53 is mounted, and the other includes a heat dissipation plate to dissipate heat, and wherein a difference between a thickness of the first metal layer 41 and a thickness of the second metal layer 42 is 0.02 mm or less.

According to the fourth feature, in the ceramic substrate 1 as described by any one of the first to third features, the insulating base 2 has a rectangular shape, and wherein an amount of warpage of the insulating base 2 in every 100 mm in a direction along each side of the insulating base 2 is 0.03 mm or less.

According to the fifth feature, a ceramic substrate manufacturing method to continuously manufacture a plurality of the ceramic substrates 1 as described by any one of the first to fourth features, includes forming the first brazing material layers 31 by applying a brazing material 30 to the first main surfaces 2a of the plurality of insulating bases 2; forming the second brazing material layers 32 by applying a brazing material 30 to the second main surfaces 2b of the plurality of insulating bases 2; and forming the first metal layers 41 and the second metal layers 42 by placing metal sheets respectively over the first brazing material layers 31 and the second brazing material layers 32 and then performing brazing, wherein in the forming the first brazing material layers and the forming the second brazing material layers, by using screen printing performed in such a manner that the brazing material 30 is pushed out toward the insulating base 2-side by a squeegee while replenishing the brazing material 30 onto a screen 7 for a plurality of times, the brazing material 30 is applied to a plurality of the insulating bases 2 after a replenishment of the brazing material 30 and before a next replenishment of the brazing material 30, and wherein for each of the insulating bases 2, a number-of-times value indicating how many times screen printing has been performed after replenishing the brazing material 30 in the forming the first brazing material layers is matched with a number-of-times value indicating how many times screen printing has been performed after replenishing the brazing material 30 in the forming the second brazing material layers.

Although the embodiment of the invention has been described, the invention according to claims is not to be limited to the embodiment described above. Further, please note that not all combinations of the features described in the embodiment are necessary to solve the problem of the invention.

In addition, the invention can be appropriately modified and implemented without departing from the gist thereof. For example, although the example in which the ceramic substrate 1 is a collective substrate and is divided into the plural ceramic divided substrates 11 to 14 has been described in the embodiment, the present invention is not limited thereto. The invention can also be applied to ceramic substrates that are not the collective substrates.

**Claims**

1. A ceramic substrate, comprising:

   a flat plate-shaped insulating base comprising a ceramic;
   a first brazing material layer provided on a first main surface of the insulating base;
   a second brazing material layer provided on a second main surface of the insulating base;
   a first metal layer comprising a metal and being fixed through the first brazing material layer to the insulating base on a first main surface-side; and
   a second metal layer comprising a metal and being fixed through the second brazing material layer to the insulating base on a second main surface-side,
   wherein a difference between a thickness of the first brazing material layer and a thickness of the second brazing material layer at a given point is 4.0 $\mu$m or less.

2. The ceramic substrate according to claim 1, wherein a relational expression $(Ta-Tb)/Ta \leq 0.2$ is satisfied where Ta is the larger of the thickness of the first brazing material layer and the thickness of the second brazing material layer at a given point and Tb is the smaller of the two.

3. The ceramic substrate according to claim 1 or 2, wherein one of the first metal layer and the second metal layer comprises a circuit plate on which an electrical circuit component is mounted, and the other comprises a heat dissipation plate, and wherein a difference between a thickness of the first metal layer and a thickness of the second metal layer is not more than 0.02 mm.

4. The ceramic substrate according to any one of claims 1 to 3, wherein the insulating base has a rectangular shape, and wherein an amount of warpage of the insulation base in every 100 mm in a direction along each side of the insulation base is not more than 0.03 mm.

5. A ceramic divided substrate that is formed by dividing the ceramic substrate according to any one of claims 1 to 4 into a plurality of pieces.

6. A ceramic substrate manufacturing method to continuously manufacture a plurality of the ceramic substrates according to any one of claims 1 to 4, the method comprising:

   forming the first brazing material layers by applying a brazing material to the first main surfaces of the plurality of the insulating bases;
   forming the second brazing material layers by applying a brazing material to the second main surfaces of the plurality of the insulating bases; and
   forming the first metal layers and the second metal layers by placing metal sheets respectively over the first brazing material layers and the second brazing material layers and then performing brazing,
   wherein in the forming the first brazing material layers the forming the second brazing material layers, by using screen printing performed in such a manner that the brazing material is pushed out toward the insulating base side by a squeegee while replenishing the brazing material onto a screen for a plurality of times, the brazing material is applied to a plurality of the insulating bases after a replenishment of the brazing material and before a next replenishment of the brazing material, and

wherein for each of the insulating bases, a number-of-times value indicating how many times screen printing has been performed after replenishing the brazing material in the forming the first brazing material layers is matched with a number-of-times value indicating how many times screen printing has been performed after replenishing the brazing material in the forming the second brazing material layers.

**FIG. 1A**

**FIG. 1B**

**FIG. 1C**

FIG. 2A

FIG. 2B

EP 4 253 348 A1

## FIG. 3

## FIG. 4

# FIG. 5

FIG. 6A

FIG. 6B

FIG. 6C

EP 4 253 348 A1

Europäisches Patentamt
European Patent Office
Office européen des brevets

# EUROPEAN SEARCH REPORT

Application Number

EP 23 16 4450

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2021/200242 A1 (DOWA METALTECH CO LTD [JP]) 7 October 2021 (2021-10-07) | 1-5 | INV. C04B37/02 |
| Y | * example 1 * | 6 | |
| X | US 2018/057412 A1 (KATO HIROMASA [JP] ET AL) 1 March 2018 (2018-03-01) | 1,2,4,5 | |
| Y | * table 7 * | 6 | |
| X | JP H09 69672 A (TOSHIBA CORP [JP]) 11 March 1997 (1997-03-11) | 1-5 | |
| Y | * examples 1-3 * | 6 | |
| X | JP 2010 050415 A (MITSUBISHI MATERIALS CORP) 4 March 2010 (2010-03-04) | 1-5 | |
| Y | * paragraph [0016] – paragraph [0025] * | 6 | |
| X | JP 2013 211545 A (HITACHI METALS LTD) 10 October 2013 (2013-10-10) | 1,2,4,5 | |
| Y | * figure 3; examples 15,26,31 * | 6 | |

TECHNICAL FIELDS SEARCHED (IPC)

C04B

The present search report has been drawn up for all claims

| Place of search | Date of completion of the search | Examiner |
|---|---|---|
| The Hague | 28 July 2023 | Raming, Tomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
......................................................................
& : member of the same patent family, corresponding document

EPO FORM 1503 03.82 (P04C01)

17

**ANNEX TO THE EUROPEAN SEARCH REPORT
ON EUROPEAN PATENT APPLICATION NO.**

EP 23 16 4450

This annex lists the patent family members relating to the patent documents cited in the above-mentioned European search report.
The members are as contained in the European Patent Office EDP file on
The European Patent Office is in no way liable for these particulars which are merely given for the purpose of information.

28-07-2023

| Patent document cited in search report | | | Publication date | Patent family member(s) | | | Publication date |
|---|---|---|---|---|---|---|---|
| WO 2021200242 | A1 | | 07-10-2021 | CN | 115151371 | A | 04-10-2022 |
| | | | | EP | 4130308 | A1 | 08-02-2023 |
| | | | | JP | 2021159926 | A | 11-10-2021 |
| | | | | KR | 20220156516 | A | 25-11-2022 |
| | | | | US | 2023068210 | A1 | 02-03-2023 |
| | | | | WO | 2021200242 | A1 | 07-10-2021 |
| US 2018057412 | A1 | | 01-03-2018 | CN | 107251214 | A | 13-10-2017 |
| | | | | EP | 3358615 | A1 | 08-08-2018 |
| | | | | JP | 6829204 | B2 | 10-02-2021 |
| | | | | JP | 7000544 | B2 | 19-01-2022 |
| | | | | JP | 7000545 | B2 | 19-01-2022 |
| | | | | JP | 2021052205 | A | 01-04-2021 |
| | | | | JP | 2021052206 | A | 01-04-2021 |
| | | | | JP | WO2017056666 | A1 | 12-07-2018 |
| | | | | US | 2018057412 | A1 | 01-03-2018 |
| | | | | WO | 2017056666 | A1 | 06-04-2017 |
| JP H0969672 | A | | 11-03-1997 | JP | 2698780 | B2 | 19-01-1998 |
| | | | | JP | H0969672 | A | 11-03-1997 |
| JP 2010050415 | A | | 04-03-2010 | JP | 5045613 | B2 | 10-10-2012 |
| | | | | JP | 2010050415 | A | 04-03-2010 |
| JP 2013211545 | A | | 10-10-2013 | JP | 6182903 | B2 | 23-08-2017 |
| | | | | JP | 2013211545 | A | 10-10-2013 |

EPO FORM P0459

For more details about this annex : see Official Journal of the European Patent Office, No. 12/82

**REFERENCES CITED IN THE DESCRIPTION**

**Patent documents cited in the description**

- JP 2022054654 A
- JP 2021159926 A
- JP 2003309210 A